# EUROPEAN PATENT SPECIFICATION

(11) **EP 0 358 530 B1**
(45) Date of publication and mention of the grant of the patent: **20.04.1994**
(21) Application number: 89309162.9
(22) Date of filing: 08.09.1989
(51) Int. Cl.: C04B 35/00, C04B 35/64, H01L 39/24

(54) **Novel method for producing ceramic bodies**
Verfahren zur Herstellung von keramischen Körpern
Procédé pour la production de corps céramiques

(30) Priority: 09.09.1988 US 242934
(43) Date of publication of application: 14.03.1990
(73) Proprietor: THE DOW CHEMICAL COMPANY, Midland Michigan 48640-1967 (US)
(72) Inventor: Prunier, Arthur R., Jr., Midland Michigan 48640 (US); Russell, Patrick M., Freeland Michigan 48623 (US); Spangenberg, Stanley F., Midland Michigan 48640 (US); Leddy, James J., Midland Michigan 48640 (US); Wijeyesekera, Sunil, Midland Michigan 48640 (US); McDonald, Robert R., Traverse City Michigan 49684 (US); Pechenik, Alexander, Los Angeles California 90064 (US)
(74) Representative: Raynor, John

(56) References cited:
- EP-A- 0 298 647
- ADVANCED CERAMIC MATERIALS, vol. 3, no. 5, September 1988, pages 524-526; K. SADANANDA et al.: "Effect of hot isostatic pressing on RBa2Cu3O7 superconductors"
- SUPERCONDUCTIVITY AND ITS APPLICATIONS, 20th April 1988, pages 94-99, H.S. KWOK et al. editors, Elsevier Science Publishing Co., Inc.; B.C. HENDRIX et al.: "Hot isostatic pressing (HIP) of oxide superconductors"

## Description

This invention concerns superconducting ceramic bodies and a process for converting certain inorganic starting materials into ceramic bodies suitable for use in superconductive applications.

Some methods known for preparing ceramic bodies involve (a) hot pressing of powdered or compacted samples in a close-fitting, rigid mold or (b) hot isostatic pressing ("hipping") a sealed, deformable container having disposed therein a powdered or compacted sample utilizing a gas as the pressure-transmitting medium. In both of these methods, the sample, whether originally a powder or compact, assumes the shape of the mold or deformed container. Several problems are encountered when such methods are used. For example, the sizes and shapes of articles that can be produced are limited. In addition, finished ceramic bodies having complex shapes often contain undesirable density gradients because of nonuniform pressure distribution during pressing. Also, each sample must be compressed in a separate mold or container and, after hot pressing, the sample often adheres to the mold or container during separation.

Isostatic pressing of self-sustaining compacts (e.g., ceramic preforms) has been suggested as a possible method of overcoming the above-mentioned problems. For example, U. S. Patent 3,279,917 discloses the use of a particulate material such as powdered glass or graphite as a pressure-transmitting medium in the hot pressing or refractory bodies. In this method, the particulate pressure-transmitting medium does not conform completely to the sample. As a consequence, pressure is still not transmitted uniformly and truly isostatically. Various shapes such as cubes, round rods and the like are distorted when nonuniform pressure is applied. It is therefore quite difficult, if not virtually impossible, to form intricate contours by this method.

U. S. Patent 3,455,682 discloses an improved method of hot isostatically pressing (i.e., "hipping") refractory bodies which comprises the following steps:
(A) surrounding the body with a mixture consisting essentially of from 5 percent to 40 percent by weight of a first component selected from alkali and alkaline earth metal chlorides, fluorides and silicates and mixtures thereof and from 60 to 95 percent by weight of a second component selected from silica, alumina, zirconia, magnesia, calcium oxide, spinels, mullite, anhydrous aluminosilicates and mixtures thereof;
(B) heating said mixture to a temperature at which it is plastic; and (C) while maintaining said temperature, applying to said mixture sufficient pressure to increase the density of said body. It is taught that in this manner, low porosity, refractory bodies having a variety of shapes and sizes can be compressed to extremely low porosity and very high density without substantially altering their original shape.

U. S. Patent 4,428,906 discloses a method for densifying material of metallic and nonmetallic compositions and combinations thereof to form a densified compact of a predetermined density. A quantity of such material which is less dense than the predetermined density, is encapsulated in a pressure-transmitting medium. External pressure is applied to the entire exterior of the medium to cause the predetermined densification of the encapsulated material. Densification occurs by way of hydrostatic pressure applied by the medium in response to the medium being substantially fully dense and incompressible but capable of fluidic flow, at least just prior to the predetermined densification. The invention is characterized by utilizing a pressure-transmitting medium of a rigid interconnected skeletal structure, which is collapsible in response to a predetermined force, and fluidizing means capable of fluidity. The fluidizing means is supported by and retained within the skeletal structure. The fluidizing means and the skeletal structure forms a composite of skeletal structure fragments dispersed in the fluidizing means in response to collapse of the skeletal structure at the predetermined force. The predetermined force renders the composite substantially fully dense and incompressible and fluidic at the predetermined densification of the compact.

U.S. Patent 4,562,090 discloses a method of densifying a coating on the substrate by use of thermal and compressive stresses using a gas or solid pressure transfer medium. The substrates are steels, metal alloys or metals or non-ferrous metal alloys. The coatings are metal alloys, metals, particularly high wear and corrosion resistant metal alloys.

Surprisingly, ceramic articles having superconducting qualities are provided by a process for densifying ceramic materials by use of a combination of heat and isostatic pressure which results in a densified ceramic body that is at a least 85 percent of theoretical density. The densified superconducting article may be of any highly complex shape at a density.

The invention concerns a method for preparing superconducting ceramic articles. The process comprises:-
a. heating a powdered admixture of three separate components, that are: (1) a rare earth metal oxide or a source thereof which oxide is yttria (Y₂O₃), lanthana (La₂O₃), neodymia (Nd₂O₃), samaria (Sm₂O₃), europium oxide (Eu₂O₃), gadolinia (Gd₂O₃), dysprosia (Dy₂O₃), holmium sesquioxide (Ho₂O₃), erbia (Er₂O₃), thulia (Tm₂O₃), ytterbia (Yb₂O₃) or lutetium oxide (Lu₂O₃), (20 barium monoxide or a source thereof (3) cupric oxide or a source therefor to a temperature which is high enough to allow the admixture to be densified under pressure to more than 65 percent of the admixture's theoretical density, and which is at least 30 percent (°C) of the melting temperature of said admixture but below said melting temperature;
b) applying to said heated admixture isostatic pressure of from 80,000 psi (5.5 x 10² MPa) up to the fracture stress of said heated admixture, preferably for a period of from 0.1 second to ten minutes such that a densified article with a density of more than 65 percent of the admixture's theoretical density is formed. In a preferred embodiment the invention comprises
   a. heating a powdered admixture of a source of yttria, a source of barium monoxide and a source of cupric oxide to a temperature which is high enough to allow the admixture to be densified under pressure to more than 65 percent of the admixture's theoretical density at least 30 percent of the melting temperature of the admixture but below said melting temperature;
   b. applying to said heated admixture isostatic pressure which is greater than or equal to 80,000 psi (5.5 x 10² MPa) but less than a pressure at which said heated admixture fractures, for a period of time sufficient to form a densified article with a density of more than 65 percent of the admixture's theoretical density, said period of time being preferably from 0.1 second to ten minutes.

The superconductivity characteristics of the ceramic articles of the invention are enhanced by annealing, in the presence of gaseous oxygen, at a temperature of 850 to 1000°C and cooling at 0.5 to 1.5°C/min.

The superconducting ceramic article so produced is suitably of the formula YBa₂Cu₃O₇₋ₓ where 0<x<1. X is beneficially <0.6, but >0.

In a related aspect, superconducting articles are prepared by substituting other rare earth metal oxides for yttria. "Rare earth metal oxides", as used herein, refers to materials selected from the group consisting of lanthana (La₂O₃), neodymia (Nd₂O₃), samaria (Sm₂O₃), europium oxide (Eu₂O₃), gadolinia (Gd₂O₃), dysprosia (Dy₂O₃), holmium sesquioxide (Ho₂O₃), erbia (Er₂O₃), thulia (Tm₂O₃), ytterbia (Yb₂O₃) and lutetium oxide (Lu₂O₃).

In a second related aspect, further variation of the starting materials will produce other superconducting articles. Such other articles include those comprising compounds of the formula A₂B₂₋ₓCa_{n-1+y}Cu_{n+z}O₄₊₂ₙ, where A is bismuth and B is strontium or A is thallium and B is calcium, 0<x<1, 0<y<1, -1<z<1 and n is an integer, beneficially from 1 to 10, desirably 2 or 3. Other suitable, superconducting articles result from a substitution of up to 50 percent of the bismuth with lead or up to 38 percent of the calcium with yttrium.

In a third related aspect, additional variation of the starting materials will produce still more superconducting articles. These articles comprise compounds of the formula TlBa₂₋ₓCa_{n-1+y}Cu_{n+z}O₄₊₂ₙ, where 0<x<1, 0<y<1, -1<z<1 and n is an integer, beneficially from 1 to 10, desirably 2, 3 or 4; compounds of the formula La₂₋ₓBaₓCuO_{y} or La₂₋ₓSrₓCuO_{y} where 0<x<0.4 and 3<y<5; compounds of the formula BaPb₁₋ₓBiₓO_{y} where 0.05<x<0.3 and 2<y<3; or compounds of the formula BaₓK_{y}BiO_{z}, where 0.5<x<0.7, 0.4<y<0.8 and 2<z<3.

Ceramic material compositions suitable for use in preparing superconducting articles include a source of yttria or other rare earth oxide, a source of barium monoxide and a source of cupric oxide. The source of yttria is beneficially selected from the group consisting of yttria, yttrium acetate, yttrium carbonate, yttrium nitrate hexahydrate and yttrium nitrate tetrahydrate. The source of yttria is desirable yttria itself. The source of barium monoxide is beneficially selected from the group consisting of barium monoxide, barium acetate, barium acetate hydrate, barium peroxide, barium carbonate (α), barium carbonate (β), barium carbonate (γ), and barium nitrate. The source of barium monoxide is desirably barium monoxide itself. The source of cupric oxide is beneficially selected from the group consisting of cupric oxide, cuprous oxide, copper acetate, copper carbonate, copper nitrate hexahydrate and copper nitrate trihydrate. The source of cupric oxide is desirably cupric oxide itself.

Superconducting articles also result when the aforementioned compositions are modified by substituting a source of a rare earth metal oxide other than yttria for the yttria. The rare earth metal oxides other than yttria include materials selected from the group consisting of lanthana (La₂O₃), neodymia (Nd₂O₃), samaria (Sm₂O₃), europium oxide (Eu₂O₃), gadolinia (Gd₂O₃), dysprosia (Dy₂O₃), holmium sesquioxide (Ho₂O₃), erbia (Er₂O₃), thulia (Tm₂O₃), ytterbia (Yb₂O₃) and lutetium oxide (Lu₂O₃). Sources for the rare earth metal oxides are both similar to those for yttria and readily determined by skilled artisans without undue experimentation.

In one preferred embodiment, the ceramic material to be densified is particulate and has a particle size of 100 µm or less, more preferably 10 µm or less; still more preferably 1 µm or less and most preferably between 0.01 and 1 µm. The description of preferred particle sizes is given for a substantially mono-modal particle size distribution. It will be recognized by those skilled in the art that smaller quantities of particles of considerably smaller size than the size of the main proportion of particulate may be intermixed therewith to achieve a higher packing density for a given degree of densification.

In one preferred embodiment of this invention, fibrous ceramic material or other reinforcing ceramic material may be mixed with the particulate ceramic material. It is believed that incorporation of fibrous ceramic material or other reinforcing ceramic material may increase the strength and fracture toughness of the ceramic body produced.

In accordance with the aspect of the present invention wherein a ceramic body is produced, the ceramic material may be compressed and shaped in a preliminary operation to preferably generate a ceramic preform having the desired shape of the final product. Said ceramic preform will preferably have sufficient density to substantially retain its shape during handling and further processing. In practice, the ceramic preform may be prepared by placing the ceramic material in a press and partially densifying the material by pressure application. The resulting partially densified material may be referred to as a ceramic preform. Such pressing is normally done under ambient temperatures. Internal lubricants such as waxes, or a material such as polyethylene, may be used during preparation of the ceramic preform to produce a higher density. An external lubricant, such as Methocel® or zirconium nitride, may be used to prevent galling of a die punch in a press, (e.g., a uniaxial press). In one preferred embodiment, a rigid mold may be used to apply the pressure. Suitable pressures are generally between 200 psi (1.4 MPa) and 10,000 psi (6.89 x 10¹ MPa). In another preferred embodiment, the ceramic material may be pressed directly in a steel or tungsten carbide die in a powder metallurgy press. In a third preferred embodiment, the ceramic material may be charged into a thin-walled rubber mold which is evacuated, sealed and subjected to isostatic pressure in a liquid medium at ambient temperatures and pressures of from 1,000 psi (6.89 MPa) to 30,000 psi (2.1 x 10² MPa). In one preferred embodiment, the ceramic preform, prepared by any of the above processes, has a density of between 30 percent and 85 percent, more preferably between 60 and 85 percent.

The conditions at which the ceramic material is densified may be critical in the preparation of a ceramic body. Four desirable parameters are: (1) the additives to enhance binding, (2) the temperature at which the binding proceeds, (3) the pressure used to achieve such binding, and (4) the time period over which such pressure is applied. It is further desired that the pressure be applied in a substantially isostatic manner. Isostatic pressure refers herein to pressure which is applied evenly to all portions of the material to be densified, regardless of shape or size.

The particular additives, pressure, temperature and time to give the desired results are dependent upon the particular ceramic material chosen. Those skilled in the art may choose the appropriate additives, pressures, temperatures and times based upon the teachings contained herein.

Temperatures useful for preparing ceramic bodies in accordance with this invention are preferably between the lowest temperature which the ceramic material is sufficiently plastic to permit compaction sufficient to achieve the desired density,e.g., about 30 percent of the melting temperature of the ceramic material, and less than the melting temperature of said material,e.g., about 2000°C and more preferably between 30 percent and 95 percent of the melting temperature of the ceramic material. The melting temperature may be measured in either degrees Celsius or degrees Fahrenheit. Even more preferably, the temperature is between 50 and 70 percent of the melting temperature of the ceramic material. For purposes of this invention, the melting temperature is that temperature at which the ceramic material undergoes a phase change from a solid to a liquid state. In cases where the melting temperature is unknown, said temperature may be estimated by standard methods known to those skilled in the art. It must be recognized that the temperatures which are useful for a particular ceramic material may be dependent upon the properties of that material, and one skilled in the art would recognize those temperatures which are useful based upon the functional description provided. Preferably, the temperature is greater than that at which a pressure of 100,000 psi (6.9 x 10² MPa) will achieve at least 86 percent of the theoretical density within 2 seconds and less than that temperature at which the ceramic material undergoes recrystallization and grain growth.

When preparing ceramic bodies in accordance with the present invention, the pressure applied to the ceramic material is preferably between 50,000 psi (3.45 x 10² MPa) and the fracture stress of said material; more preferably between 70,000 psi (4.82 x 10² MPa) and said fracture stress; and most preferably between 100,000 psi (6.89 x 10² MPa) and said fracture stress. Fracture stress, as referred to herein, is defined as that pressure which, when applied to a ceramic material, causes said material to fracture. It is believed that if true isostatic pressure is applied to the ceramic material, then said material will not fracture and therefore no fracture stress exists. However, due to mechanical imperfections and particle interactions in applying pressure to a ceramic material, said material may exhibit a fracture stress. The maximum pressure applied is preferably less than 1,000,000 psi (7.0 x 10³ MPa), and more preferably less than 450,000 psi (3.1 x 10³ MPa).

In a preferred embodiment of this invention, the pressure is applied in a substantially isostatic manner and in an amount sufficient to permanently reduce the volume (i.e., densification) of the ceramic material. Preferably, the pressure is applied in an amount sufficient to densify the ceramic material to at least 85 percent of theoretical density in less than 15 minutes at a temperature below the melting temperature of the ceramic material. Although satisfactory results may be obtained when pressure is applied for longer time periods, e.g., up to an hour or more, it is believed that such time periods are uneconomical. More preferably the pressure is sufficient to accomplish the above-described densification in less than 1 minute, even more preferably in less than 10 seconds, and most preferably in less than 5 seconds. A rate of pressure increase greater than 1,000 psi/sec (6.89 MPa/sec) is preferred and a rate of pressure increase greater than 10,000 psi/sec (6.89 x 10¹ MPa/sec) is more preferred. It is believed that if the pressure used is too high, the ceramic bodies prepared may fracture and if the pressure used is too low, the ceramic bodies prepared may have a density too low for desired uses.

In accordance with this invention, pressure is applied for a sufficient time to densify the ceramic material to a predetermined density. The time in which the ceramic material is exposed to the desired pressure is preferably between that time sufficient for said material to reach at least 85 percent of its theoretical density and that time in which the ceramic material fractures. It has been discovered that times of between 0.01 second and one hour are generally suitable for achievement of the desired densification. The preferred time for achievement of the desired densification is between 0.01 second and 15 minutes; more preferred is between 0.1 second and 10 minutes; even more preferred is between 0.1 second and 1 minute; even more preferred is between about 0.1 second and about 10 seconds; still more preferred is between 0.5 second and 5 seconds and still more preferred is between 1 second and 5 seconds. The most preferred time is 2 seconds.

In accordance with that aspect of the present invention wherein a superconducting ceramic article is prepared, the process comprises two steps. In step one, a powdered admixture comprising a source of a rare earth metal oxide, a source of barium monoxide and a source of cupric oxide is heated to a temperature which is high enough to allow the admixture to be densified under pressure to more than about 65 percent of the admixture's theoretical density but low enough to substantially preclude melting of the admixture. The rare earth metal oxide is selected from the group consisting of yttria, lanthana (La₂O₃), neodymia (Nd₂O₃), samaria (Sm₂O₃), europium oxide (Eu₂O₃), gadolinia (Gd₂O₃), dysprosia (Dy₂O₃), holmium sesquioxide (Ho₂O₃), erbia (Er₂O₃), thulia (Tm₂O₃), ytterbia (Yb₂O₃) and lutetium oxide (Lu₂O₃). The rare earth metal oxide is beneficially yttria, and the temperature is suitably 800°C to 900°C, beneficially from 850°C to 875°C. Temperatures suitable for the other rare earth metal oxides are readily attainable without undue experimentation. In step two, isostatic pressure of 80,000 psi (5.5 x 10² MPa) to the fracture stress of the heated admixture is applied to said heated admixture for a period of time sufficient to form a densified article with a density of more than 65 percent of the admixture's theoretical density. The pressure is suitably 90,000 psi (6.2 x 10² MPa) and 120,000 psi (8.3 x 10² MPa). The density of the densified article is beneficially more than 85 percent, desirably more than 90 and preferably more than 95 percent of the admixture's theoretical density. The period of time is beneficially 0.1 second to ten minutes, desirably ten seconds to five minutes.

A particularly desirable modification of the foregoing process involves a preliminary step wherein the powdered admixture is placed in a container before said admixture is heated. The container is beneficially fabricated from a material which is substantially fully dense and incompressible at room temperature, but capable of plastic flow at the elevated temperatures and pressures of steps one and two. The container preferably has defined therein a cavity having a shape approximating that of the resultant superconducting ceramic article. Suitable container materials include those metals from which the admixture components are derived as well as those which are substantially nonreactive with said admixture during this process. One such material is copper. Copper also offers other advantages such as ready availability and relatively low cost. In addition, copper and its reaction products with admixture components are either readily removed or of no concern as far as superconductive or mechanical properties of the resultant ceramic article are concerned.

Another desirable modification of the foregoing process concerns an additional step which beneficially follows the preliminary step of placing the admixture in a container. The additional step may also be inserted between steps one and two if desired. The additional step comprises at least partially containing the powdered admixture in a pressure-transmitting medium which is fluidic when subjected to the pressure of step two.

The foregoing process benefically also comprises a sequential step three wherein the densified article is annealed under conditions sufficient to convert it to a superconducting ceramic article. When the rare earth metal oxide is yttria, the superconducting ceramic article has a composition comprising YBa₂Cu₃O₇₋ₓ where 0<x<0.6. The conditions beneficially comprise heating the densified article in the presence of gaseous oxygen to a temperature of 850°C to 1000°C and thereafter slowly cooling the heated, densified article, in the presence of gaseous oxygen, to a temperature of 500°C. Cooling is beneficially at a rate of cooling which is sufficiently low to allow the densified article to absorb enough oxygen to render the article superconductive. The rate of cooling is suitably 0.5 to 1.5°C per minute.

The foregoing process beneficially further comprises a sequential step four wherein the cooled, densified article is held at a temperature of 400°C to 500°C in the presence of oxygen for a period of time sufficient to further increase the oxygen content of the densified article. Time periods of 15 minutes to 48 hours produce satisfactory results.

The ceramic bodies and superconducting ceramic articles of this invention may be prepared in a substantially solid state process. A solid state process refers herein to a procedure whereby the ceramic material is densified while in a substantially solid state. The prior art teaches that the ceramic material may undergo recrystallization and agglomeration of the ceramic particles during densification resulting in large ceramic grain particles. It is believed that one advantage of this invention is that it allows significantly lower temperatures and, in some instances, reduces densification times of ceramic bodies thereby minimizing grain growth during densification.

It should be recognized that there are practical considerations which will dominate the selection of the proper time, temperature and pressure variables according to this invention. Generally, the time variable may be minimized (in terms of utility of this invention) to avoid getting into temperature/time ranges so high that appreciable reshaping and coarsening of the grain structure begins to occur. High pressure and high temperature both accelerate ceramic flow. Therefore, both should be maximized subject to the constraint that the grains should not appreciably increase in size. It is believed that at the particular temperatures and pressure used in this invention there may be enhanced mobility of dislocations in the ceramic body during densification. It will be evident to those skilled in the art that grain growth inhibitors may be used to extend the range of practice of this invention.

Isostatic pressure may be applied to the ceramic material of the ceramic preform. Various methods of applying isostatic pressure are known to those skilled in the art. All such methods which allow for the use of the preferred parameters of time, temperature and pressure as described hereinabove are useful.

One such preferred method of transmitting isostatic pressure to a material to be bound and densified is described in Rozmus, U. S. Patent 4,428,906 The process described therein involves first placing the powder of the binder material and the ceramic material in the proportion desired in a container which is capable of performing as a pressure-transmitting medium at temperatures and pressures used for densification of the powders. That is, the container must be flexible or deformable yet maintain structural integrity at elevated temperatures. As noted herein, suitable container materials for use in preparing superconducting ceramic articles include those metals from which the admixture components or preformed compositions are derived as well as those which are substantially nonreactive with said admixture or preformed composition during the process. By way of illustration, copper is particularly suitable for compositions such as YBa₂Cu₃O₇₋ₓ wherein 0<x<0.6.

The container is suitably evacuated, e.g., with a vacuum or reduced pressure, prior to addition of the binder material and ceramic material thereto. The materials are suitably added under vacuum. The container, with the less dense powder therein, is then placed in a casting mold wherein a pressure-transmitting medium is cast about the container to encapsulate the entire container and the less dense powder material. The pressure-transmitting medium is solidified so as to retain its configuration and removed from the casting mold.

The pressure-transmitting medium includes a rigid interconnected skeletal structure which is collapsible when a predetermined force is applied. The skeletal structure may be of a ceramic-like material which is rigid and retains its configuration, but which may be broken up, crushed, fractionated or caused to flow at a predetermined relatively minimal force. The skeletal structure is defined by the ceramic material being interconnected to form a framework, latticework or matrix. The pressure-transmitting medium is further characterized by including a fluidizing means or material capable of fluidity and supported by and retained within the skeletal structure. The fluidizing material may, among other materials, be glass or elastomeric material. In other words, glass granules or particles are disposed in the openings or interstices of the skeletal structure so as to be retained and supported by the skeletal structure. A preferred transmitting medium may be formed by mixing a slurry of structural material in wetting fluid or activator with particles or granules of a fluidizing material dispersed therein.

The encapsulated, less than fully dense, material is heated to a compaction temperature prior to the densification. This can be done by placing the encapsulated container and powder in a furnace and raising it to a temperature at which compaction at the desired pressure or force will take place. During such heating, the glass or other fluidizing material supported by the skeletal structure softens and becomes fluidic and capable of plastic flow and incapable of retaining its configuration without the skeletal structure at the compaction temperature to which the powder has been heated for densification. However, the skeletal structure retains its configuration and rigidity at the compaction temperature. The heated pressure-transmitting medium may be handled without losing its configuration after being heated to the compaction temperature so it may be placed within a pot die. The pressure-transmitting medium which encapsulates the container and less dense powder is then placed in a press such as one having a cup-shaped pot die which has interior walls extending upward from the upper extremity of the pressure-transmitting medium. Thereafter, a ram of a press is moved downward in close-sliding arrangement with the interior walls to engage the pressure medium. The ram therefore applies a force to a portion of the exterior pressure-transmitting medium while the pot die restrains the remainder of the pressure-transmitting medium so that the desired external pressure is applied to the entire exterior of the pressure-transmitting medium and the pressure-transmitting medium acts as a fluid to apply hydrostatic pressure to densify the powder to the desired densification. When the external pressure is applied on the pressure-transmitting medium, the skeletal structure is crushed and becomes dispersed within the fluidizing means such that the pressure applied is then directly transmitted by the fluidizing means to the container containing the powder to be densified.

Thereafter, the densified material encapsulated within the pressure-transmitting medium may be cooled. The pressure-transmitting medium may then be a rigid and frangible brick which may be removed from the container by shattering it into fragments, as by striking with a hammer or the like.

One preferred container useful for the densifi- cation of powdered binder material and refractory ceramic material using isostatic pressure is disclosed by U.S. Reissue Patent 31,355. This patent discloses a container for hot consolidating powder which is made of substantially fully dense and incompressible material wherein the material is capable of plastic flow at pressing temperatures and that, if the container walls are thick enough, the container material will act as a fluid upon the application of heat and pressure to apply hydrostatic pressure to the powder. Under such conditions, the exterior surface of the container need not conform to the exterior shape of the desired refractory body prepared.

Such containers can be made of any material which retains its structural integrity but is capable of plastic flow at the pressing temperatures. Included among acceptable materials would be low carbon steel, other metals with the desired properties, glass, ceramics or combinations thereof. The choice of the particular material would depend upon the temperatures at which the particular binder material and refractory ceramic material would be densified. Generally, two pieces of the material which would be used to make the container are machined to prepare a mold which has upper and lower die sections. These are thereafter joined along their mating surfaces such that the upper and lower die sections form a cavity having a predetermined desired configuration. The size and shape of the cavity is determined in view of the final shape of the part to be produced. Before the upper and lower die sections are assembled, a hole is drilled in one of the die sections and a fill tube is inserted. After the fill tube has been attached, the two die sections are placed in a mating relationship and welded together. Care is taken during welding to ensure that a hermetic seal is produced to permit evacuation. Thereafter, the container is evacuated and filled with the powder to be densified through the fill tube. The fill tube is then hermetically sealed by pinching it closed and welding it.

Thereafter, the container is exposed to isostatic pressure at the desired binding and densification temperatures. This can be done by the methods described hereinabove. Alternatively, the filled and sealed container can be placed in an autoclave, and subjected to the temperatures and pressures desired for the binding and densification. The pressure in the autoclave on the container is isostatic and because the container is able to retain its configuration and has plastic-like tendencies, the container will exert isostatic pressure on the powders to be densified. The size of the cavity in the container will shrink until the powder therein reaches the desired density. After densification, the container can be removed from the autoclave and cooled. The container is then removed from the densified refractory material by pickling in a nitric acid solution. Alternatively, the container can be removed by machining or a combination of rough machining followed by pickling.

In the practice of the invention, a container is prepared as described in U.S. Reissue Patent 31,355 described hereinabove and the isostatic pressure can be exerted on such container as described hereinabove. The container, once the powdered binder and refractory ceramic material are densified, is exposed to temperatures at which such container will melt without affecting the properties of the refractory body so prepared. Thereafter, the molten material or metal which has been melted away from the refractory body can thereafter be recycled to form a new container.

Other preferred methods of applying isostatic pressure through a pressure-transmitting medium to the ceramic preform are described in U.S. Patents 3,455,682; 4,142,888; 4,094,709; 4,255,103; 3,230,286; 3,824,097; 4,023,966; 3,650,646; 3,841,870; 4,041,123; 4,077,109; 4,081,272; and 4,339,271.

In a preferred embodiment, the ceramic preform may be encapsulated in a protective barrier prior to placing the ceramic preform in a container as described hereinabove. The use of a barrier may prevent glass from penetrating into pores in the ceramic body during the hot pressing and may facilitate removal of the ceramic body from the glass/ceramic die because of differential expansion and barrier toughness. The protective barrier may be any metal which has a melting point greater than that of the glass/ceramic die, is substantially inert to the processing of the ceramic body and is plastically deformable. A preferred protective barrier may comprise tantalum, gold, platinum, other relatively inert metals and alloys thereof.

The ceramic bodies of this invention preferably have a density of 85 percent or greater, more preferably 90 percent or greater, even more preferably 95 percent or greater, and most preferably 100 percent. High density refers herein to a density of 90 percent or greater of theoretical density.

The ceramic bodies of this invention preferably have an average grain size of 100 microns or less: more preferably 10 microns or less; still more preferably 1 or less; and most preferably between 0.01 and 1 µm.

The following examples are included for illustrative purposes only, and are not intended to limit the scope of the invention or claims. Unless otherwise stated, all parts and percentages are by volume.

### Example 1 - Preparation of a Superconducting Material Consolidation

A mixture consisting of 112.9 grams of yttria, 329.7 grams of 93% barium monoxide (the remaining 7% constitutes barium hydroxide or barium carbonate) and 238.6 grams cupric oxide is dry milled at 60 rpm for about twelve hours using 350 cubic centimeters of high alumina content ceramic balls, commercially available under the trade designation Burundum™ from U. S. Stoneware Co., as a milling media in a 2000 milliliter wide mouth polyethylene jar. Approximately 220 grams of the mixture is transferred to a copper can having an internal diameter of 2 1/2 inches and a length of 7/8 inch (6.4 cm x 2.2 cm). The can and its contents are heated in an air oven to a temperature of 850°C and held at that temperature for twenty minutes. The can and its contents are then placed in a soda lime glass fluid pocket die, transferred to a forging press and subjected to 120,000 psi (830 MPa) of substantially isostatic pressure for a period of five seconds. After cooling, the copper can is removed to reveal a densified material having a green surface. The green surface is removed by grinding to reveal a black material which, when analyzed by x-ray diffraction, has the structure of the oxygen deficient tetragonal modification of YBaₓCu₃O₇₋ₓ. The material has a density of 5.4 g/cm³ (about 88 percent of theoretical based upon the oxygen deficient structure). Densities as high as 5.79g/cm³ (about 94 percent of theoretical based upon the oxygen deficient structure) may be obtained with this consolidation process.

### Annealing

Portions of the consolidated material are subjected to two different annealing programs with gaseous oxygen flowing past the portions at a rate of 2.5 cm (one inch) per minute. One program, which does not produce a superconducting material, is as follows: heat the material at a rate of 10°C per minute from 200°C to 700°C; cool the heated material at a rate of 1/2°C per minute from 700°C to 500°C; hold the material at 500°C for thirty minutes; and cool the material at a rate of 10°C per minute from 500°C to 200°C. The second program, which does produce a superconducting material, is as follows: heat the material at a rate of 10°C per minute from 200°C to 800°C; heat the material at a rate of 1/2°C per minute from 800°C to 900°C; hold the material at 900°C for six hours; cool the heated material at a rate of 1°C per minute from 900°C to 600°C; hold the material at 600°C for one hour; cool the material at a rate of 1°C per minute from 600°C to 500°C; hold the material at 500°C for twenty minutes; and cool the material at a rate of 10°C per minute from 500°C to 200°C.

### Verification of Superconductivity

The annealed samples are placed in a magnetometer to verify the presence or absence of superconductive phases. The sample annealed according to the first program exhibits no superconductivity. The sample annealed according to the second program provides a diamagnetic signal of 24% of the theoretical value (1/4π emu/cc). The signal disappears upon heating the material above 94° K.

The foregoing results show the importance of the annealing conditions. It is believed that heating above 800°C, preferably in the range of 850°C to 875°C, is necessary if superconductivity is to be attained. It is also believed that heating above about 900°C during annealing may lead to formation of parasitic melt phases such as Ba₃Cu₅O₈ which may lower critical current density. Similar results are obtained with other compositions and process variations within the scope of the present invention.

## Claims

1. A method for preparing a superconducting ceramic article, comprising:
a. heating a powdered admixture of three separate components, that are: (1) a rare earth metal oxide or a source thereof which oxide is yttria (Y₂O₃), lanthana (La₂O₃), neodymia (Nd₂O₃), samaria (Sm₂O₃), europium oxide (Eu₂O₃), gadolinia (Gd₂O₃), dysprosia (Dy₂O₃), holmium sesquioxide (Ho₂O₃), erbia (Er₂O₃), thulia (Tm₂O₃), ytterbia (Yb₂O₃) or lutetium oxide (Lu₂O₃), (2) barium monoxide or a source thereof (3) cupric oxide or a source therefor to a temperature which is high enough to allow the admixture to be densified under pressure to more than 65 percent of the admixture's theoretical density, and which is at least 30 percent (°C) of the melting temperature of said admixture but below said melting temperature;
b. applying to said heated admixture isostatic pressure of from 80,000 psi (5.5 x 10² MPa) up to the fracture stress of said heated admixture, for a period such that a densififed article with a density of more than 65 percent of the admixture's theoretical density is formed.

2. The method of Claim 1 wherein, prior to step a, the powdered admixture is placed in a container formed from a material which is substantially fully dense and incompressible at room temperature but capable of plastic flow at elevated temperatures and pressures, said container having defined therein a cavity which has a shape approximating that of the article.

3. The method of Claim 2 wherein the material is copper.

4. The method of any one of the preceding claims wherein, prior to step b, the powdered admixture is at least partially contained in a pressure-transmitting medium which is fluidic when subjected to the pressure of said step b.

5. The method of any one of the preceding claims wherein said pressing is carried out at a pressure of from 90,000 psi (6.2 x 10² MPa) to 120,000 psi (8.3 x 10² MPa).

6. The method of any one of the preceding claims wherein the said application of pressure is carried out for a period of from ten seconds to five minutes

7. The method of any one of the preceding claims wherein the said temperature is at least 800°C and less than 900°C.

8. The method of any one of the preceding claims wherein the densified article has a density of more than 85 percent of the admixture's theoretical density.

9. The method of any one of the preceding claims wherein the rare earth metal oxide or source thereof is yttria, yttrium acetate, yttrium carbonate, yttrium nitrate hexahydrate or yttrium nitrate tetrahydrate.

10. The method of any one of the preceding claims wherein component (2) is barium monoxide, barium acetate, barium acetate hydrate, barium peroxide, barium carbonate (alpha), barium carbonate (beta), barium carbonate (gamma), or barium nitrate.

11. The method of any one of the preceding claims wherein component (3) is cupric oxide, cuprous oxide, copper acetate, copper carbonate, copper nitrate hexahydrate or copper nitrate trihydrate.

12. The method of any one of the preceding claims wherein the admixture comprises yttria, barium monoxide and cupric oxide.

13. The method of any one of the preceding claims, further comprising:
c) annealing the densified article under conditions sufficient to convert said densified article to a superconducting ceramic article having a composition comprising YBa₂Cu₃O₇-x where 0<x<0.6, by heating the densified article in the presence of gaseous oxygen to a temperature of 850°C to 1000°C and thereafter slowly cooling the heated, densified article, in the presence of gaseous oxygen, to a temperature of about 500°C, at a rate of cooling of 0.5 to 1.5°C per minute which is sufficiently low to allow the densified article to absorb enough oxygen to render the article superconductive.

14. The method of Claim 13, further comprising: holding the cooled, densified article at a temperature of from 400°C to 500°C in the presence of oxygen for from 15 minutes to 48 hours to further increase the oxygen content of the densified article.

## Patentansprüche

1. Verfahren zur Herstellung eines supraleitenden keramischen Artikels, welches umfaßt:
a) Erhitzen eines gepulverten Gemisches aus 3 getrennten Komponente, die (1) ein Seltenerdmetalloxid oder eine Quelle dafür sind, wobei das Oxid Yttriumoxid (Y₂O₃), Lanthanoxid (La₂O₃), Neodymoxid (Nd₂O₃), Samariumoxid (Sm₂O₃), Europiumoxid (Eu₂O₃), Gadoliniumoxid (Gd₂O₃), Dyprosiumoxid (Dy₂O₃), Holmium Sesquioxid (Ho₂O₃), Erbiumoxid (Er₂O₃), Thuliumoxid (Tm₂O₃) Ytterbiumiumoxid (Yb₂O₃) oder Lutetiumoxid (Lu₂O₃) ist, (2) Bariumoxid oder eine Quelle dafür sind, (3) Kupfer(II)oxid oder eine Quelle dafür sind, auf eine Temperatur, die ausreichend hoch ist, um die Verdichtung des Gemisches unter Druck auf mehr als 65 % der theoretischen Dichte des Gemisches zu ermöglichen und die mindestens 30 % (°C) der Schmelztemperatur des Gemisches, jedoch unterhalb der Schmelztemperatur, ist
b) Ausüben eines isostatischen Druckes von 80000 Psi (5,5 10² MPa) auf das erhitzte Gemisch bis zur Bruchspannung des erhitzen Gemisches für eine derartige Zeitspanne, daß ein verdichteter Artikel mit einer Dichte von mehr als 65 % der theoretischen Dichte des Gemisches gebildet wird.

2. Verfahren nach Anspruch 1, bei dem das gepulverte Gemisch vor Schritt a in einen Behälter überführt wird, der aus einem Material besteht, das bei Raumtemperatur im wesentlichen vollkommen dicht und nicht komprimierbar ist, bei erhöhten Temperaturen und Drücken jedoch zum plastischen Fluß befähigt ist, wobei der Behälter innen einen Hohlraum aufweist, der in etwa die Gestalt des Artikels besitzt.

3. Verfahren nach Anspruch 2, bei dem das Material Kupfer ist.

4. Verfahren nach einem der vorhergehenden Ansprüche, bei dem das gepulverte Gemisch vor Schritt b mindestens teilweise in einem Druck-übertragenden Medium enthalten ist, das wenn es dem Druck in Schritt b ausgesetzt wird, fluid ist.

5. Verfahren nach einem der vorhergehenden Ansprüche, bei dem das Pressen bei einem Druck von 90000 Psi (6,2x10² MPa) bis 120000 Psi (8,3x10² MPa) durchgeführt wird.

6. Verfahren nach einem der vorhergehenden Ansprüche, bei dem das Ausüben von Druck für eine Zeitspanne von 10 Sekunden bis 5 Minuten durchgeführt wird.

7. Verfahren nach einem der vorhergehenden Ansprüche, bei dem die Temperatur mindestens 800°C und weniger als 900°C beträgt.

8. Verfahren nach einem der vorhergehenden Ansprüche, bei dem der verdichtete Artikel eine Dichte von mehr als 85 % der theoretischen Dichte des Gemisches aufweist.

9. Verfahren nach einem der vorhergehenden Ansprüche, bei dem das Seltenerdmetalloxid oder die Quelle dafür Yttriumoxid, Yttriumacetat, Yttriumcarbonat, Yttriumnitrat-Hexahydrat oder Yttriumnitrat-Tetrahydrat ist.

10. Verfahren nach einem der vorhergehenden Ansprüche, bei dem die Komponente (2) Bariumoxid, Bariumacetat, Bariumacetat-Hydrat, Bariumperoxid, Bariumcarbonat (alpha), Bariumcarbonat (beta), Bariumcarbonat (gamma) oder Bariumnitrat ist.

11. Verfahren nach einem der vorhergehenden Ansprüche, bei dem die Komponente (3) Kupfer(II)oxid, Kupfer(I)oxid, Kupferacetat, Kupfercarbonat, Kupfernitrat-hexahydrat und Kupfernitrat-Trihydrat ist.

12. Verfahren nach einem der vorhergehenden Ansprüche, bei dem das Gemisch Yttriumoxid, Bariumoxid und Kupfer(II)oxid umfaßt.

13. Verfahren nach einem der vorhergehenden Ansprüche, das weiter umfaßt:
Tempern des verdichteten Artikels unter Bedingungen, die zur Umwandlung des verdichteten Artikels in einen supraleitenden keramischen Artikel mit einer YBa₂Cu₃O₇₋ₓ umfassenden Zusammensetzung, wobei 0<x<0,6 ist, ausreichend sind, indem der verdichtete Artikel in Anwesenheit von gasförmigem Sauerstoff auf eine Temperatur von 850°-1000°C erhitzt und anschließend der heiße, verdichtete Artikel in Anwesenheit von gasförmigem Sauerstoff auf eine Temperatur von etwa 500°C langsam abgekühlt wird, bei einer Abkühlungsgeschwindigkeit von 0,5° bis 1,5°C/min, die ausreichend niedrig ist, damit der verdichtete Artikel genügend Sauerstoff absorbieren kann, um den Artikel supraleitend zu machen.

14. Verfahren nach Anspruch 13, welches weiter umfaßt:
Halten des gekühlten, verdichteten Artikels bei einer Temperatur von 400°C bis 500°C in Anwesenheit von Sauerstoff für 15 Minuten bis 48 Stunden, um den Sauerstoffgehalt des verdichteten Artikels weiter zu erhöhen.

## Revendications

1. Procédé pour préparer un article céramique supraconducteur, comprenant les étapes consistant:
a. à chauffer un mélange en poudre de trois composants séparés qui sont (1) un oxyde de métal rare ou une de ses sources, oxyde qui est l'oxyde d'yttrium (Y₂O₃), l'oxyde de lanthane (La₂O₃), l'oxyde de néodyme (Nd₂O₃), l'oxyde de samarium (Sm₂O₃), l'oxyde d'europium (Eu₂O₃), l'oxyde de gadolinium (Gd₂O₃), l'oxyde de dysprosium (Dy₂O₃), le sesquioxyde d'holmium (Ho₂O₃), l'oxyde d'erbium (Er₂O₃), l'oxyde de thullium (Tm₂O₃), l'oxyde d'ytterbium (Yb₂O₃) ou l'oxyde de lutétium (Lu₂O₃), (2) le monoxyde de baryum ou une de ses sources, (3) l'oxyde cuivrique ou une de ses sources, à une température qui est assez élevée pour permettre au mélange de prendre sous pression une densité qui est de plus de 65% de la densité théorique du mélange, et à une température qui est au moins 30 pourcent (en °C) de la température de fusion dudit mélange mais au-dessous de ladite température de fusion;
b. à appliquer audit mélange chauffé une pression isostatique qui est comprise entre 5,5 x 10² MPa (80 000 psi) et la pression de rupture dudit mélange chauffé, pendant une durée telle qu'il se forme un article densifié avec une densité supérieure à 65 pourcent de la densité théorique du mélange.

2. Procédé selon la revendication 1, dans lequel avant l'étape 1, le mélange sous forme de poudre est placé dans un récipient formé à partir d'un matériau qui est pratiquement entièrement dense et incompressible à la température ambiante mais capable de fluage plastique à des températures et pressions élevées, ledit récipient ayant en lui une cavité qui a une forme voisine de celle de l'article.

3. Procédé selon la revendication 2, dans lequel le matériau est le cuivre.

4. Procédé selon l'une quelconque des revendications précédentes, dans lequel, avant l'étape b, le mélange sous forme de poudre est au moins partiellement contenu dans un milieu de transmission de la pression qui est fluide quand on le soumet à la pression de ladite étape b.

5. Procédé selon l'une quelconque des revendications précédentes, dans lequel on effectue ledit pressage à une pression comprise entre 6,2 x 10² MPa (90 000 psi) et 8,3 x 10² MPa (120 000 psi).

6. Procédé selon l'une quelconque des revendications précédentes dans lequel on réalise ladite application pendant une durée de dix secondes à cinq minutes.

7. Procédé selon l'une quelconque des revendications précédentes, dans lequel ladite température est d'au moins 800°C et inférieure à 900°C.

8. Procédé selon l'une quelconque des revendications précédentes, dans lequel l'article densifié a une densité de plus de 85 pourcent de la densité théorique du mélange.

9. Procédé selon l'une quelconque des revendications précédentes dans lequel l'oxyde de métal des terres rares ou sa source est l'oxyde d'yttrium, l'acétate d'yttrium, le carbonate d'yttrium, le nitrate d'yttrium hexahydraté ou le nitrate d'yttrium tétrahydraté.

10. Procédé selon l'une quelconque des revendications précédentes, dans lequel le composant (2) est le monoxyde de baryum, l'acétate de baryum, l'acétate de baryum hydraté, le peroxyde de baryum, le carbonate de baryum (alpha), le carbonate de baryum (béta), le carbonate de baryum (gamma), ou le nitrate de baryum.

11. Procédé selon l'une quelconque des revendications précédentes, dans lequel le composant (3) est l'oxyde cuivrique, l'oxyde cuivreux, l'acétate de cuivre, le carbonate de cuivre, le nitrate de cuivre, le nitrate de cuivre hexahydraté ou le nitrate de cuivre trihydraté.

12. Procédé selon l'une quelconque des revendications précédentes, dans lequel le mélange comprend l'oxyde d'ytrrium, le monoxyde de baryum et l'oxyde cuivrique.

13. Procédé selon l'une quelconque des revendications précédentes, comprenant de plus:
c) le recuit de l'article densifié dans des conditions suffisantes pour convertir ledit article densifié en un article céramique supraconducteur ayant une composition comprenant YBa₂Cu₃O₇₋ₓ où 0<x<0,6, en chauffant l'article densifié en présence d'oxygène gazeux à une température de 850°C à 1000°C et par la suite en refroidissant lentement l'article chauffé, densifié, en présence d'oxygène gazeux, à une température d'environ 500°C, à une vitesse de refroidissement de 0,5 à 1,5°C par minute qui est suffisamment faible pour permettre à l'article densifié d'absorber suffisamment d'oxygène pour rendre l'article supraconducteur.

14. Procédé selon la revendication 13, comprenant l'étape consistant à maintenir l'article refroidi, densifié à une température de 400°C à 500°C en présence d'oxygène pendant une durée de 15 minutes à 48 heures pour augmenter encore la teneur en oxygène de l'article densifié.
